# FASCICULE DE BREVET EUROPEEN

(11) **EP 2 605 029 B1**
(45) Date de publication et mention de la délivrance du brevet: **03.12.2014**
(21) Numéro de dépôt: 12195377.2
(22) Date de dépôt: 04.12.2012
(51) Int. Cl.: G01R 33/00, G01R 33/035, G01R 33/025

(54) **Dispositif porte-échantillon pour magnétomètre**
Probenhalter für ein Magnetometer
Sample holder for magnetometer

(30) Priorité: 16.12.2011 FR 1161750
(43) Date de publication de la demande: 19.06.2013
(73) Titulaire: COMMISSARIAT A L'ENERGIE ATOMIQUE ET AUX ENERGIES ALTERNATIVES, 75015 Paris (FR)
(72) Inventeur: Dubois, Lionel, 73460 Verrens-Arvey (FR); Jacquot, Jean-François, 38760 Varces (FR)
(74) Mandataire: Vuillermoz, Bruno

(56) Documents cités:
- US-A1- 2011 094 376
- TOMITA T ET AL: "Enhanced superconducting properties of bicrystalline YBa2Cu3Ox and alkali metals under pressure; Superconducting properties of alkali metals", JOURNAL OF PHYSICS: CONDENSED MATTER, INSTITUTE OF PHYSICS PUBLISHING, BRISTOL, GB, vol. 17, no. 11, 23 mars 2005 (2005-03-23) , pages S921-S928, XP020088831, ISSN: 0953-8984, DOI: 10.1088/0953-8984/17/11/024

## Description

### DOMAINE DE L'INVENTION

L'invention se rapporte à un porte-échantillon, destiné à être mis en oeuvre au sein d'un magnétomètre. On entend par magnétomètre (magnétomètre, susceptomètre), un dispositif apte à mesurer les propriétés magnétiques d'un échantillon. Il comporte une chambre de mesure, dans laquelle un échantillon est maintenu au moyen d'un dispositif adapté, appelé porte-échantillon, et soumis à l'action d'un champ magnétique.

Ce porte-échantillon comprend un récipient cylindrique, apte à recevoir l'échantillon à analyser, et un bouchon cylindrique destiné à fermer hermétiquement le récipient et à entrer en contact avec l'échantillon.

### ETAT DE LA TECHNIQUE

Pour la détermination des propriétés magnétiques d'un échantillon, dans l'absolu et de manière idéale, il conviendrait de pouvoir analyser ledit échantillon isolément, afin de pouvoir déterminer sa propre signature magnétique. Or, de manière connue, tout objet présente des propriétés magnétiques. Comme un porte-échantillon est nécessaire pour placer ledit échantillon au sein d'un magnétomètre, il en résulte que ledit porte-échantillon génère lui-même sa propre signature magnétique, interférant de fait avec la signature de l'échantillon analysé.

Tout changement dans l'épaisseur, la masse, la densité ou la susceptibilité magnétique du matériau utilisé produit un signal. Par conséquent, la matière et la géométrie du porte-échantillon utilisé contribuent toujours, d'une façon plus ou moins importante, à la signature magnétique de l'échantillon à analyser.

Ainsi, pour mesurer les propriétés magnétiques d'un échantillon, on procède usuellement à la mesure de la signature magnétique provenant du porte-échantillon seul, puis on soustrait la valeur mesurée à la valeur brute, c'est-à-dire la valeur du signal obtenu par le porte-échantillon renfermant l'échantillon à analyser. Plus la signature magnétique du porte-échantillon est faible, plus la valeur déduite pour les propriétés magnétiques de l'échantillon est fiable et précise, d'autant plus que les propriétés magnétiques sont déterminées en fonction d'une gamme de champs magnétiques, et pour une valeur de champ magnétique donnée, en fonction d'une gamme de températures, au sein de la chambre de mesure.

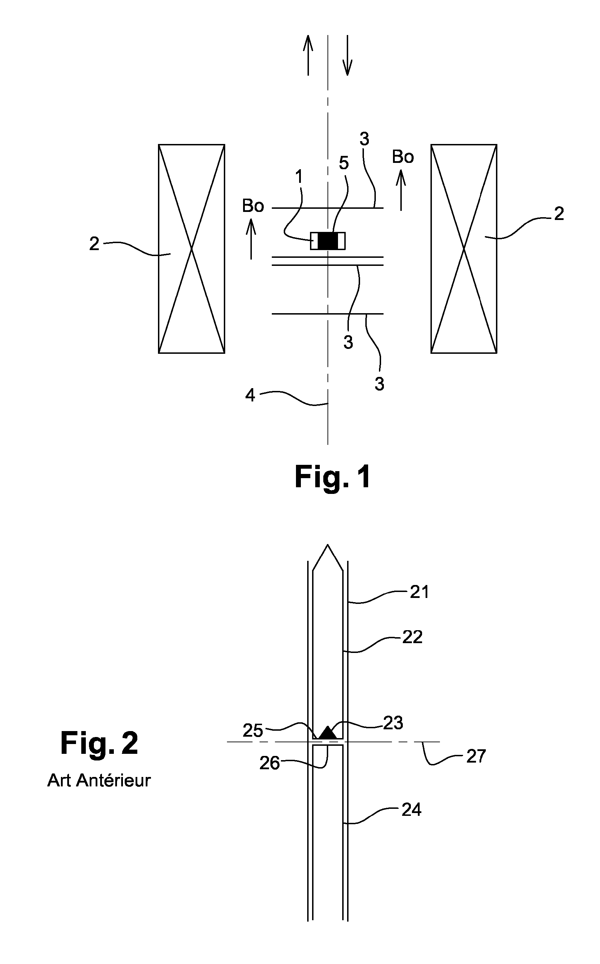

On a représenté en relation avec la figure 1, une vue schématique en section sagittale d'un porte-échantillon de l'état antérieur de la technique, mis en place au sein d'un magnétomètre. Le porte-échantillon (1) est usuellement disposé au centre de la bobine (2) qui génère le champ magnétique B₀ au sein de la chambre de mesure du magnétomètre. Ledit champ magnétique B₀ est orienté de manière sensiblement parallèle à l'axe longitudinal (4) du porte-échantillon (1), c'est-à-dire l'axe selon lequel est susceptible de se déplacer le porte-échantillon. De plus, l'échantillon (5) est disposé sensiblement à équidistance des bords de la bobine (2), et se déplace selon cet axe longitudinal (appelé également axe de champ principal) dans une zone où ce champ est homogène. La mesure est effectuée par trois bobines (3) de mesure du flux induit dans ces trois bobines par le déplacement de l'échantillon.

Afin d'obtenir des mesures de magnétisme fiables, le porte-échantillon (1) est conçu de manière à ce que le flux qu'il induit dans les bobines de mesure soit le plus faible possible.

Typiquement, le dispositif selon l'art antérieur ainsi décrit donne une signature magnétique du porte-échantillon très importante en fonction de la position dudit porte-échantillon le long de son axe longitudinal dans la chambre de mesure, donc une signature magnétique trop importante devant la signature magnétique de l'échantillon. Pour minimiser ce flux, il faudrait que le porte-échantillon soit continu, homogène et infiniment long devant l'espacement entre les bobines de mesure. Comme il y a nécessairement une discontinuité au niveau de l'échantillon, il faudrait en plus que cette discontinuité soit la plus courte possible, toujours par rapport à l'espacement entre les bobines de mesure, et soit symétrique pour qu'elle se comporte, vis-à-vis desdites bobines de mesure, comme un dipôle magnétique.

En outre, la chambre de mesure du magnétomètre qui contient l'échantillon doit être propre et exempte de toute contamination par des matériaux étrangers. Ainsi, la perte de l'échantillon dans la chambre de mesure doit être évitée à tout prix.

D'une manière générale, les porte-échantillon utilisés dans l'état de l'art pour effectuer des mesures de magnétisme par un magnétomètre à SQUID (pour l'expression anglo-saxonne *« Superconducting QUantum Interference Device* »), sont réalisés en matière plastique, comme par exemple le polychlorotrifluoroéthylène (Kel F^{™}), en verre, par exemple de type silice ou borosilicate, ou en métal, comme par exemple l'aluminium.

D'un point de vue pratique, l'un des meilleurs matériaux pour réaliser ces porte-échantillon est constitué par la silice. La silice présente en effet l'avantage d'une signature magnétique relativement faible, mais surtout constante en fonction de la température à laquelle est réalisée la mesure à l'intérieur de la chambre de mesure, ce qui facilite les corrections et l'étalonnage du porte-échantillon.

Lorsque l'on veut mesurer les propriétés magnétiques d'un échantillon sensible à l'air, comme des poudres, voire d'un échantillon liquide, l'échantillon est généralement scellé dans un tube en verre. Ce procédé permet de diminuer les risques de contamination, notamment de l'utilisateur, dans le cas d'un échantillon dangereux pour la santé humaine, et/ou de la chambre de mesure, dans le cas d'un échantillon à forte propriété magnétique. Une alternative au scellement de l'échantillon dans le porte-échantillon est l'utilisation d'une matrice, par exemple une matrice époxy, pour emprisonner la poudre.

Dans la pratique, la mesure des propriétés magnétiques des échantillons sensibles à l'air est réalisée au moyen de tubes destinés aux mesures de résonance magnétique nucléaire (RMN) et résonance électronique paramagnétique (EPR). Ces tubes sont choisis pour la qualité des matériaux qui les composent, à savoir le verre ou la silice et leur faible susceptibilité magnétique, c'est-à-dire une signature magnétique faible.

Pour répondre à certaines de ces contraintes, un porte-échantillon selon l'art antérieur (figure 2), destiné à contenir un échantillon (23) sensible à l'air, comporte un tube externe (21) qui renferme un tube formant un récipient (22), de plus faibles dimensions. L'extrémité inférieure fermée du récipient (22) recevant l'échantillon, repose sur une extrémité supérieure fermée d'un tube dit de compensation (24), afin de respecter les contraintes de symétrie mentionnées ci-dessus. Le tube de compensation (24) est également disposé à l'intérieur du tube externe (21). De plus, l'extrémité supérieure du tube faisant fonction de récipient (22), opposée à l'extrémité inférieure fermée destinée à recevoir l'échantillon, est scellée par l'utilisateur.

Ce porte-échantillon présente effectivement l'avantage :
- d'être infiniment long devant l'espace compris entre les bobines ;
- d'être en silice ;
- d'être étanche.

Mais en revanche, il ne respecte pas la contrainte de symétrie par rapport à l'échantillon, car les surfaces (25) et (26) sont situées d'un même coté de l'échantillon et ne sont pas compensées par des surfaces qui auraient pu se situer de l'autre coté de l'échantillon. De plus, ce porte-échantillon n'est pas réutilisable car scellé de façon irréversible après mise en place de l'échantillon. Enfin, dans ce porte-échantillon, la poudre est libre et les grains ne sont pas maintenus dans une position figée, ce qui constitue une autre condition essentielle de ce type de mesure.

D'autres contraintes plus générales s'imposent à ces porte-échantillon. Ainsi, un tel porte-échantillon doit être facile à manipuler avec des gants, surtout lorsqu'il est au préalable enfermé dans une boîte à gants, dans le cadre d'une manipulation sous atmosphère contrôlée.

En outre, il ne doit pas présenter de risques importants de contamination de ses parois lors de son remplissage par l'échantillon lui-même, donc un risque de contamination de la chambre de mesure, et corollairement une altération de la précision des mesures.

Enfin, le positionnement et l'accrochage du porte-échantillon doivent être reproductibles pour obtenir un étalonnage rigoureux.

Le document US2011/094376 décrit un dispositif permettant de soumettre un échantillon à des fortes pressions pour des mesures de magnétométrie.

### EXPOSE DE L'INVENTION

Le but de la présente invention est de proposer un porte-échantillon qui présente une faible signature magnétique, de configuration adaptée pour réaliser des mesures aussi bien avec des échantillons solides que liquides, et une configuration permettant de limiter les entrées d'air dans le récipient qui contient l'échantillon. Elle vise également un porte-échantillon susceptible d'être réutilisé plusieurs fois, et dont le remplissage est simplifié, de telle sorte à réduire le risque de contamination de ses parois. Ce porte-échantillon a également pour vocation à être aisément manipulable, et dont la configuration permet de procéder à un tassement de l'échantillon à analyser lorsque celui-ci se présente sous forme pulvérulente.

A cet effet, l'invention a pour objet un porte-échantillon pour magnétomètre, et notamment pour magnétomètre à SQUID, qui comprend :
- un tube externe cylindrique,
- un récipient destiné à recevoir un échantillon à analyser, et
- un tube de compensation.

Selon l'invention, le tube de compensation est reçu dans le tube externe, et est ouvert à ses deux extrémités.

En outre, le récipient est posé à l'extrémité supérieure du tube de compensation, et est ouvert à son extrémité supérieure, ledit récipient étant susceptible d'être obturé par un bouchon, constitué par un tube, pourvu d'une excroissance ou saillie apte à coopérer de manière étanche avec l'extrémité supérieure du récipient, et apte à entrer en contact avec l'échantillon.

Selon l'invention, l'ensemble constitué par le tube de compensation, le récipient et le bouchon est inséré de manière colinéaire dans le tube externe, ce dernier faisant ainsi fonction de pièce de manipulation et de fixation au sein du magnétomètre.

Il résulte de cette structure que le tube faisant fonction de bouchon est amovible, notamment par rapport au récipient, simplifiant de fait l'utilisation du dispositif et permettant en outre son réemploi.

Selon l'invention, le récipient de l'échantillon à analyser se présente également sous la forme d'un tube cylindrique, les différents tubes constitutifs du tube de compensation, du récipient et du bouchon présentant sensiblement les mêmes caractéristiques physiques, notamment même matériau, même diamètre intérieur et même diamètre extérieur, le diamètre extérieur étant bien évidemment inférieur au diamètre interne du tube externe de manipulation et de fixation.

Avantageusement, le récipient de l'échantillon à analyser, le bouchon et le tube de compensation sont réalisés à partir d'un même tube.

Avantageusement, l'étanchéité entre le bouchon et le récipient résulte d'un rodage de l'excroissance ou saillie émanant dudit bouchon.

### BREVE DESCRIPTION DES FIGURES

D'autres buts et aspects avantageux de l'invention ressortiront mieux à la lecture de la description détaillée qui suit, donnée à titre indicatif et nullement limitatif à l'appui des figures annexées, dans lesquelles :
- la figure 1 est une vue schématique tendant à illustrer le principe de fonctionnement d'un magnétomètre intégrant un porte-échantillon ;
- la figure 2 est une vue schématique en coupe sagittale d'un porte-échantillon selon l'art antérieur ;
- la figure 3 est une vue schématique en coupe sagittale d'un porte-échantillon selon la présente invention, à l'état désassemblé ;
- la figure 4 est une vue schématique en coupe sagittale du porte-échantillon de la figure 3 à l'état assemblé ;
- la figure 5 est une vue schématique en coupe sagittale illustrant un procédé de préparation d'un échantillon à analyser dans un porte-échantillon conforme à l'invention ;
- la figure 6 est un tracé illustrant une comparaison des propriétés magnétiques de porte-échantillon de l'état de l'art à ceux conformes à l'invention.

### DESCRIPTION DETAILLEE DE L'INVENTION

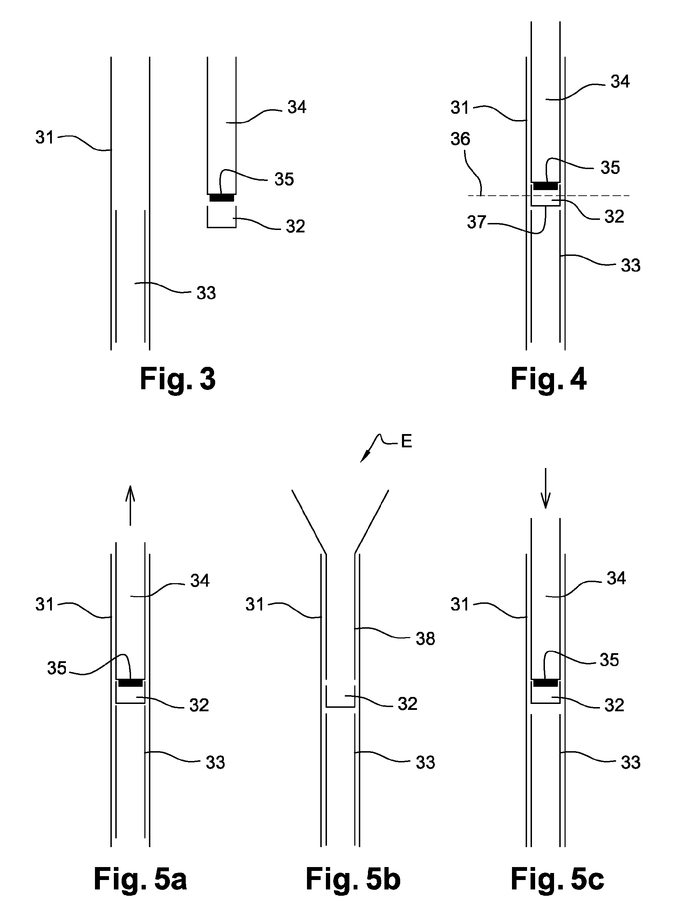

La figure 3 illustre, comme indiqué ci-dessus, un porte-échantillon pour magnétomètre, par exemple un magnétomètre à SQUID, selon l'invention.

Ce dispositif comprend un tube externe cylindrique (31), apte à contenir trois tubes internes cylindriques (32), (33), (34), sensiblement de même diamètre, respectivement :
- un premier tube interne (32) constituant un récipient cylindrique destiné à contenir un échantillon dont les propriétés magnétiques sont à analyser. Le récipient (32) comporte un fond inférieur fermé et une extrémité supérieure ouverte ;
- un deuxième tube interne (33), ouvert à chacune de ses deux extrémités, et destiné à faire fonction de tube de compensation, et sur l'extrémité supérieure duquel est destiné à reposer le fond fermé du récipient (32) ; et
- un troisième tube interne (34), ou bouchon, adapté pour obturer de manière étanche et amovible le récipient (32), afin d'enfermer hermétiquement l'échantillon dans ledit récipient (32).

Précisément, le bouchon (34) comporte une excroissance ou saillie (35) coopérant de manière amovible et hermétique avec l'extrémité ouverte du récipient (32), afin d'emprisonner hermétiquement l'échantillon dans le récipient (32), et surtout, de le comprimer afin d'immobiliser les grains qui peuvent s'aligner selon la direction du champ B₀ (dans le cas où l'échantillon est pulvérulent). En d'autres termes, la hauteur de l'excroissance ou saillie (35) est telle que lorsque l'échantillon se présente sous forme pulvérulente, les grains qui le constituent sont immobilisés dans le récipient (32).

La figure 4 montre le porte-échantillon à l'état assemblé. Le tube externe (31) renferme le tube de compensation (33) sur lequel est posé, au centre du dispositif, le tube récipient (32), qui contient un échantillon à analyser. Le bouchon (34) amovible ferme de manière hermétique le récipient (32), de sorte que l'échantillon n'est pas au contact de l'air.

Le tube externe (31) est suffisamment long pour maintenir en place le tube de compensation (33), le récipient (32) et le bouchon (34) mis bout à bout.

Le tube de compensation (33) et l'ensemble formé par le récipient (32) et le bouchon amovible (34) ont un même diamètre et des longueurs suffisamment grandes devant l'espacement entre les bobines. Cette configuration vise d'une part, à minimiser les effets de bord (grande longueur) et d'autre part, à symétriser le récipient, dans la mesure où les surfaces constituées par le fond fermé du récipient (32) et l'extrémité fermée (35) du bouchon (34) sont symétriques par rapport à l'échantillon. Cette configuration est adoptée afin de limiter la signature magnétique du porte-échantillon.

De manière avantageuse, le tube externe (31) comporte un rétrécissement, total ou partiel, ou est muni d'un adhésif, ou tout autre système de fermeture apte à maintenir en place le tube de compensation (33) de manière solidaire avec le tube externe (31).

De manière avantageuse, les différents éléments constitutifs du porte-échantillon sont réalisés en silice, en verre borosilicate, ou encore en métal, par exemple en aluminium, argent, cuivre ou autres métaux à susceptibilité magnétique faible.

Par susceptibilité magnétique massique faible, on entend une valeur absolue de χ au maximum égale à 10⁻⁵ cm³/g.

A titre exemplatif, le tube externe (31) présente un diamètre extérieur inférieur avantageusement à 9 millimètres, cette dimension étant le diamètre utile des appareils actuellement dans le commerce. Les tubes intérieurs ont avantageusement un diamètre extérieur par exemple compris entre 2 et 4 millimètres de façon à permettre leur déplacement sans frottement (jeu supérieur ou égal à 2 %) et une manipulation aisée. Dit autrement les tubes constitutifs du récipient (32), du tube de compensation (33) et du bouchon (34) ont un diamètre extérieur choisi avec un jeu supérieur ou égal à 2 % par rapport au diamètre intérieur du tube externe (31).

L'épaisseur des tubes est comprise avantageusement entre 0,1 et 1 millimètre, toujours dans un souci d'une manipulation aisée.

La découpe des tubes en verre peut être réalisée à l'aide d'un diamant ou à l'aide d'un système mécanique.

De manière avantageuse, le fond (37) du récipient (32) est plat, ceci afin de minimiser la signature magnétique propre du porte-échantillon.

De plus, il est avantageux que le fond (37) du récipient soit le plus fin possible, c'est-à-dire d'une épaisseur inférieure ou égale au millimètre, préférentiellement comprise entre 50 et 200 micromètres, pour résister aux éventuelles variations de pression rencontrées lors de la mesure, effectuée généralement sous vide, et pour résister aux efforts mécaniques liés à la compression de l'échantillon par le bouchon amovible (34).

De manière avantageuse, l'extrémité ouverte du récipient (32) et l'excroissance ou saillie (35) du bouchon (34) sont rodées l'une sur l'autre, pour permettre une adaptation hermétique des deux tubes l'un par rapport à l'autre.

De manière avantageuse, l'excroissance ou saillie (35) du bouchon (34) présente des dimensions adaptées pour induire le tassement de l'échantillon contre le fond fermé (37) du récipient (32) lorsque ledit échantillon se présente sous forme pulvérulente. On évite ainsi une éventuelle orientation privilégiée de l'échantillon au regard des lignes de champ magnétique.

Cette excroissance ou saillie (35) résulte avantageusement de l'étape de rodage du bouchon (34).

De manière avantageuse, le bouchon amovible (34) dépasse du tube externe (31), ceci afin de faciliter la manipulation du bouchon (34), surtout dans des conditions de manipulation réduite, comme dans le cas d'une utilisation de gants épais ou encore en cas d'utilisation d'une boite sous vide ou sous atmosphère contrôlée.

On peut mettre en oeuvre un entonnoir (38), afin de favoriser l'introduction de l'échantillon au sein du tube récipient (32). La tige s'étendant à partir de la zone évasée de l'entonnoir est suffisamment longue pour permettre d'atteindre le récipient (32), au sein du tube externe (31). Par ailleurs, la tige a avantageusement les mêmes diamètres intérieur et extérieur que ceux du récipient.

La figure 5 illustre un procédé de préparation de l'échantillon à analyser, dans un porte-échantillon conforme à l'invention.

Dans une première étape, la signature magnétique d'un porte-échantillon nettoyé et assemblé est mesurée et le porte-échantillon est pesé.

Lors d'une deuxième étape (figure 5a), le bouchon (34) est désolidarisé du porte-échantillon. Eventuellement et en cas de besoin, les différents éléments du dispositif peuvent être insérés séparément dans une boîte à gants contenant l'échantillon (E) à analyser.

Lors d'une troisième étape (figure 5b), un entonnoir (38) est positionné en lieu et place du bouchon (34), et le récipient (32) est rempli par transvasement pour un échantillon solide, ou par pipetage pour un échantillon liquide.

Lors d'une quatrième étape (figure 5c), l'entonnoir (38) est retiré et le récipient (32) est fermé par le bouchon (34).

Afin d'obtenir une meilleure étanchéité, il est possible de graisser légèrement le rodage du bouchon (34).

Lors d'une cinquième étape, l'échantillon et le porte-échantillon sont pesés afin de connaître par soustraction la masse de l'échantillon introduite. Puis, le bouchon (34) est bloqué, par exemple par un petit morceau d'adhésif. Les mesures magnétiques de l'échantillon dans son porte-échantillon sont effectuées, et la signature magnétique du porte-échantillon est soustraite aux valeurs obtenues.

Après usage, le porte-échantillon est démonté, le récipient (32) est vidé et les différents éléments du porte-échantillon, constitué par le tube externe (31), le tube de compensation (33), le récipient (32) et le bouchon (34), sont soigneusement nettoyés.

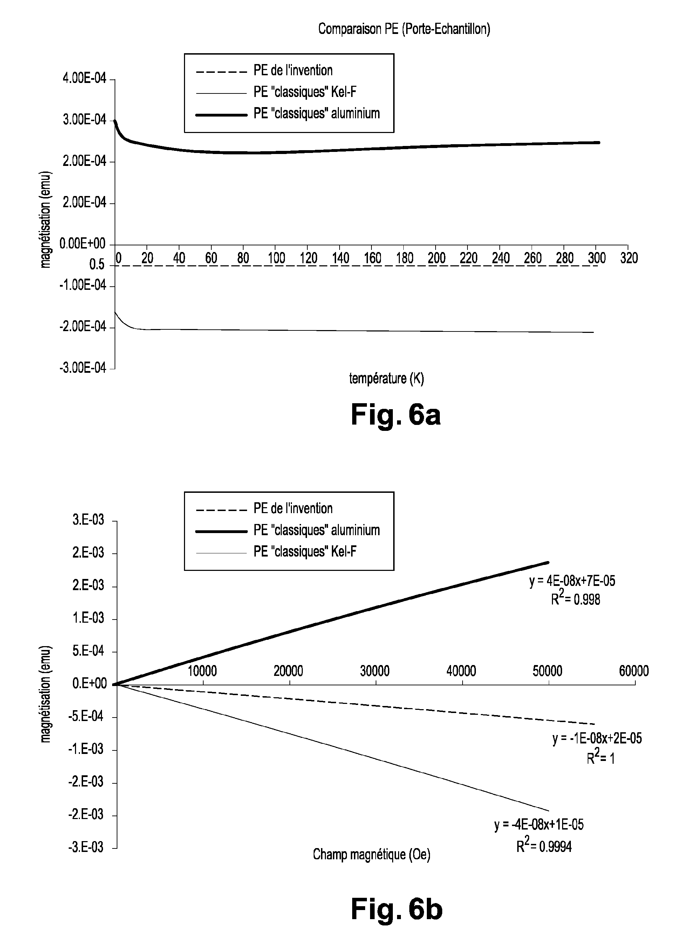

La figure 6 représente les courbes de magnétisation en fonction de la température (Figure 6a) ou du champ magnétique (Figure 6b), d'un porte-échantillon conforme à l'invention, et des porte-échantillon correspondant à l'état de l'art, réalisés soit en polychlorotrifluoroéthylène (Kel F^{™}), soit en aluminium.

D'une manière générale, il est à noter les faibles valeurs de magnétisation pour des porte-échantillon conformes à l'invention par rapport aux porte-échantillon de l'état de l'art.

La magnétisation d'un porte-échantillon selon l'invention varie très peu avec la température, 0,5.10⁻⁴ emu (élémentaire magnétique unité dans le système CGS), comparé à 2,5.10⁻⁴ et -2.10⁻⁴ emu pour un porte-échantillon en aluminium et en polychlorotrifluoroéthylène (Kel F^{™}) respectivement, pour des températures supérieures à 30 K.

En outre, la magnétisation est linéaire pour un porte-échantillon conforme à l'invention pour toutes les valeurs de température testées, ce qui n'est pas le cas pour les porte-échantillon de l'état de l'art.

La magnétisation d'un porte-échantillon conforme à l'invention est sensiblement linéaire par rapport au champ magnétique, avec un coefficient de régression de 1, alors que pour les porte-échantillon de l'état de l'art, le comportement magnétique n'est pas aussi prévisible, les coefficients de régression étant respectivement de 0,998 et 0,9994 pour les porte-échantillon en aluminium et en polychlorotrifluoroéthylène (Kel F^{™}).

Le comportement linéaire de magnétisation du porte-échantillon selon l'invention en fonction de la température ou en fonction du champ magnétique a donc pour avantage de pouvoir être utilisé après étalonnage à seulement une valeur de champ magnétique à température ambiante.

Les valeurs correspondantes à d'autres conditions peuvent être obtenues en considérant le signal indépendant de la température et une dépendance linéaire en champ. Ces approximations sont impossibles à réaliser dans le cas des porte-échantillon de l'état de l'art, ce qui oblige un étalonnage complet, et donc des temps de mesures beaucoup plus longs, outre à des précisions plus aléatoires en termes de mesure.

## Revendications

1. Porte-échantillon pour magnétomètre comprenant :
• un tube externe cylindrique (31),
• un récipient (32), destiné à recevoir un échantillon à analyser, et
• un tube de compensation (33),
***caractérisé :***
• **en ce que** le tube de compensation est reçu dans le tube externe, et est ouvert à ses deux extrémités ;
• **en ce que** le récipient (32) est posé à l'extrémité supérieure du tube de compensation, et est ouvert à son extrémité supérieure ;
• et **en ce que** ledit récipient est obturé par un bouchon, constitué par un tube (34), pourvu d'une excroissance ou saillie (35) apte à coopérer de manière étanche avec l'extrémité supérieure du récipient, et apte à entrer en contact avec l' échantillon ;
l'ensemble constitué par le tube de compensation, le récipient et le bouchon étant inséré de manière colinéaire dans le tube externe (31).

2. Porte-échantillon pour magnétomètre selon la revendication 1 ***caractérisé* en ce que** le récipient (32) de l'échantillon à analyser se présente également sous la forme d'un tube cylindrique, les différents tubes constitutifs du tube de compensation (33), du récipient (32) et du bouchon (34) présentant sensiblement les mêmes caractéristiques physiques, notamment même matériau, même diamètre intérieur et même diamètre extérieur..

3. Porte-échantillon pour magnétomètre selon l'une des revendications 1 et 2, ***caractérisé* en ce que** le tube de compensation (33), le récipient (32) et le bouchon (34) sont réalisés à partir d'un même tube.

4. Porte-échantillon pour magnétomètre selon l'une des revendications 1 à 3, ***caractérisé* en ce que** l'étanchéité entre le bouchon (34) et le récipient (32) résulte d'un rodage de l'excroissance ou saillie (35) émanant dudit bouchon.

5. Porte-échantillon pour magnétomètre selon l'une des revendications précédentes, ***caractérisé* en ce que** la hauteur de l'excroissance ou saillie (35) est telle que lorsque l'échantillon se présente sous forme pulvérulente, les grains qui le constituent sont immobilisés dans le récipient (32).

6. Porte-échantillon pour magnétomètre selon l'une des revendications précédentes, ***caractérisé* en ce que** le récipient (32) comprend un fond plat (37) d'une épaisseur inférieure ou égale à 1 millimètre.

7. Porte-échantillon pour magnétomètre selon l'une des revendications précédentes ***caractérisé* en ce que** le tube externe (31), le récipient (32), le tube de compensation (33) et le bouchon (34) sont réalisés dans un même matériau, notamment choisi parmi la silice, le verre borosilicate et les métaux.

8. Porte-échantillon pour magnétomètre selon l'une des revendications précédentes ***caractérisé* en ce que** le tube externe (31), le récipient (32), le tube de compensation (33) et le bouchon (34) sont réalisés dans un même matériau, dont la valeur absolue de la susceptibilité magnétique massique est inférieure ou égale à 10⁻⁵ cm³/g.

9. Porte-échantillon pour magnétomètre selon l'une des revendications précédentes ***caractérisé* en ce que** le diamètre extérieur du tube externe (31) est inférieur 9 millimètres.

10. Porte-échantillon pour magnétomètre selon l'une des revendications précédentes ***caractérisé* en ce que** le diamètre extérieur du récipient (32), du tube de compensation (33) et du bouchon (34) est choisi avec un jeu supérieur ou égal à 2 % par rapport au diamètre intérieur du tube externe (31).

11. Porte-échantillon pour magnétomètre selon l'une des revendications précédentes ***caractérisé* en ce que** le tube externe (31) comporte un rétrécissement total ou partiel ou est muni d'un adhésif pour assurer le maintien du tube de compensation (33) en son sein.

## Patentansprüche

1. Probenhalter für ein Magnetometer, Folgendes aufweisend:
• ein zylindrisches äußeres Rohr (31),
• ein Behältnis (32), das zur Aufnahme einer zu analysierenden Probe bestimmt ist, und
• ein Ausgleichsrohr (33),
**dadurch gekennzeichnet;**
• **dass** das Ausgleichsrohr im äußeren Rohr aufgenommen und an seinen beiden Enden offen ist;
• **dass** das Behältnis (32) am oberen Ende des Ausgleichsrohrs angesetzt und an seinem oberen Ende offen ist;
• und **dass** das Behältnis durch einen Verschluss verschlossen ist, der durch ein Rohr (34) gebildet ist, das mit einem Ansatz oder Vorsprung (35) versehen ist, der auf dichte Weise mit dem oberen Ende des Behältnisses zusammenwirken und mit der Probe in Kontakt treten kann;
wobei die durch das Ausgleichsrohr, das Behältnis und den Verschluss gebildete Einheit auf kollineare Weise in das äußere Rohr (31) eingesetzt ist.

2. Probenhalter für ein Magnetometer nach Anspruch 1, **dadurch gekennzeichnet, dass** das Behältnis (32) der zu analysierenden Probe sich ebenfalls in Form eines zylindrischen Rohrs darstellt, wobei die verschiedenen Rohre, die das Ausgleichsrohr (33), das Behältnis (32) und den Verschluss (34) bilden, im Wesentlichen dieselben physikalischen Eigenschaften, insbesondere dasselbe Material, denselben Innendurchmesser und denselben Außendurchmesser aufweisen.

3. Probenhalter für ein Magnetometer nach einem der Ansprüche 1 und 2, **dadurch gekennzeichnet, dass** das Ausgleichsrohr (33), das Behältnis (32) und der Verschluss (34) aus ein und demselben Rohr hergestellt sind.

4. Probenhalter für ein Magnetometer nach einem der Ansprüche 1 bis 3, **dadurch gekennzeichnet, dass** sich die Dichtigkeit zwischen dem Verschluss (34) und dem Behältnis (32) aus einem Schliff des vom Verschluss ausgehenden Ansatzes oder Vorsprungs (35) ergibt.

5. Probenhalter für ein Magnetometer nach einem der vorhergehenden Ansprüche, **dadurch gekennzeichnet, dass** die Höhe des Ansatzes oder Vorsprungs (35) dergestalt ist, dass, wenn sich die Probe in Pulverform darstellt, die Körner, die sie bilden, im Behältnis (32) immobilisiert sind.

6. Probenhalter für ein Magnetometer nach einem der vorhergehenden Ansprüche, **dadurch gekennzeichnet, dass** das Behältnis (32) einen flachen Boden (37) mit einer Dicke von weniger als oder gleich 1 Millimeter hat.

7. Probenhalter für ein Magnetometer nach einem der vorhergehenden Ansprüche, **dadurch gekennzeichnet, dass** das äußere Rohr (31), das Behältnis (32), das Ausgleichsrohr (33) und der Verschluss (34) aus ein und demselben Material hergestellt sind, das insbesondere aus Siliciumdioxid, Borsilikatglas oder Metallen ausgewählt ist.

8. Probenhalter für ein Magnetometer nach einem der vorhergehenden Ansprüche, **dadurch gekennzeichnet, dass** das äußere Rohr (31), das Behältnis (32), das Ausgleichsrohr (33) und der Verschluss (34) aus ein und demselben Material hergestellt sind, dessen Absolutwert der magnetischen Massensuszeptibilität kleiner als oder gleich 10⁻⁵ cm³/g ist.

9. Probenhalter für ein Magnetometer nach einem der vorhergehenden Ansprüche, **dadurch gekennzeichnet, dass** der Außendurchmesser des äußeren Rohrs (31) kleiner als 9 Millimeter ist.

10. Probenhalter für ein Magnetometer nach einem der vorhergehenden Ansprüche, **dadurch gekennzeichnet, dass** der Außendurchmesser des Behältnisses (32), des Ausgleichsrohrs (33) und des Verschlusses (34) mit einem Spiel von über oder gleich 2 % im Verhältnis zum Innendurchmesser des äußeren Rohrs (31) gewählt ist.

11. Probenhalter für ein Magnetometer nach einem der vorhergehenden Ansprüche, **dadurch gekennzeichnet, dass** das äußere Rohr (31) eine Gesamt- oder Teilverengung hat oder mit einem Adhäsionsmittel versehen ist, um den Halt des Ausgleichsrohrs (33) in seinem Inneren sicherzustellen.

## Claims

1. A sample holder for a magnetometer, comprising:
• an external cylindrical tube (31),
• a container (32), intended to receive a sample to be analyzed, and
• an expansion pipe (33),
***characterized in that**:*
• the expansion pipe is received in the external tube, and is open at its two ends;
• the container (32) is placed at the upper end of the expansion pipe, and is open at its upper end;
• said container is closed by a stopper, formed by a tube (34), provided with a projection (35) capable of tightly cooperating with the upper end of the container, and capable of coming into contact with the sample;
the assembly formed by the expansion pipe, the container, and the stopper being collinearly inserted into the external tube (31).

2. The sample holder for a magnetometer of claim 1, ***characterized in that*** the container (32) of the sample to be analyzed is also provided in the form of a cylindrical tube, the different tubes forming the expansion pipe (33), the container (32), and the stopper (34) substantially having the same physical characteristics, particularly the same material, the same inner diameter, and the same outer diameter.

3. The sample holder for a magnetometer of any of claims 1 and 2, ***characterized in that*** the expansion pipe (33), the container (32), and the stopper (34) are formed from a same tube.

4. The sample holder for a magnetometer of any of claims 1 to 3, ***characterized in that*** the tightness between the stopper (34) and the container (32) results from a running in of the projection (35) protruding from said stopper.

5. The sample holder for a magnetometer of any of the foregoing claims, ***characterized in that*** the height of the projection (35) is such that when the sample is in powder form, the grains forming it are immobilized in the container (32).

6. The sample holder for a magnetometer of any of the foregoing claims, ***characterized in that*** the container (32) comprises a flat bottom (37) having a thickness smaller than or equal to 1 millimeter.

7. The sample holder for a magnetometer of any of the foregoing claims, ***characterized in that*** the external tube (31), the container (32), the expansion pipe (33), and the stopper (34) are made of a same material, particularly selected from among silica, borosilicate glass, and metals.

8. The sample holder for a magnetometer of any of the foregoing claims, ***characterized in that*** the external tube (31), the container (32), the expansion pipe (33), and the stopper (34) are made of a same material, having a mass magnetic susceptibility of absolute value smaller than or equal to 10⁻⁵ cm³/g.

9. The sample holder for a magnetometer of any of the foregoing claims, ***characterized in that*** the external diameter of the external tube (31) is smaller than 9 millimeters.

10. The sample holder for a magnetometer of any of the foregoing claims, ***characterized in that*** the external diameter of the container (32), of the expansion pipe (33), and of the stopper (34) is selected with a clearance greater than or equal to 2% with respect to the inner diameter of the external tube (31).

11. The sample holder for a magnetometer of any of the foregoing claims, ***characterized in that*** the external tube (31) comprises a total or partial narrowing or is provided with an adhesive to maintain the expansion pipe (33) therein.
